Europäisches Patentamt

European Patent Office

Office européen des brevets

(19)

(11) **EP 0 828 145 B1**

(12) **FASCICULE DE BREVET EUROPEEN**

(45) Date de publication et mention
de la délivrance du brevet:
**23.10.2002 Bulletin 2002/43**

(51) Int Cl.⁷: **G01J 5/20**, H01L 27/146

(21) Numéro de dépôt: **97401893.9**

(22) Date de dépôt: **06.08.1997**

(54) **Détecteur infrarouge et procédé de fabrication de celui-ci**

Infrarot-Detektor und Verfahren zu dessen Herstellung

Infrared detector and process for manufacturing it

(84) Etats contractants désignés:
**DE GB IT**

(30) Priorité: **08.08.1996 FR 9610005**

(43) Date de publication de la demande:
**11.03.1998 Bulletin 1998/11**

(73) Titulaire: **COMMISSARIAT A L'ENERGIE
ATOMIQUE**
**75015 Paris (FR)**

(72) Inventeurs:
• **Vilain, Michel**
**38450 Saint-Georges-De-Commiers (FR)**
• **Yon, Jean-Jacques**
**Rivoire de la Dame, 38360 Sassenage (FR)**

(74) Mandataire: **Dubois-Chabert, Guy et al**
**BREVATOME**
**3, rue du Docteur Lanceraux**
**75008 Paris (FR)**

(56) Documents cités:
EP-A- 0 534 424          EP-A- 0 534 768
EP-A- 0 566 156          WO-A-93/25878
US-A- 4 640 629

• **E. IBORRA ET AL.: "A NEW DESIGN OF A
SEMICONDUCTOR BOLOMETER ON RIGID
SUBSTRATE FOR FUSION PLASMA
DIAGNOSTICS" REVIEW OF SCIENTIFIC
INSTRUMENTS, vol. 64, no. 7, juillet 1993, NEW
YORK US, pages 1714-1717, XP000387100**

# Description

## Domaine technique

La présente invention concerne un détecteur infrarouge et le procédé de fabrication de celui-ci. Elle se rapporte au domaine des détecteurs de rayonnement infrarouge, et plus précisément aux microbolomètres résistifs opérant à température ambiante.

## Etat de la technique antérieure

Les détecteurs de rayonnements optiques reposent sur divers modes d'interaction rayonnement/matière, par exemple les détecteurs dits quantiques, photoconducteurs, photovoltaïques, convertissent directement l'énergie du rayonnement en porteurs électriques libres. Ces porteurs sont collectés par des moyens adéquats, tels qu'une polarisation naturelle ou une polarisation appliquée au détecteur, et constituent la source du signal électrique, fonction de l'éclairement reçu par le détecteur. D'autres détecteurs appelés bolomètres, particulièrement adaptés au rayonnement infrarouge, convertissent l'énergie en échauffement. Le signal produit est l'image de la température du détecteur. La conversion signal thermique/signal électrique est le résultat d'une propriété électrique, conductivité, susceptibilité diélectrique ou autre, d'un matériau ou assemblage de matériaux du bolomètre, variable avec la température. De manière très simplifiée, les performances d'un détecteur quantique sont proportionnelles au nombre de porteurs collectés pour un éclairement donné. Les performances d'un bolomètre sont proportionnelles à l'élévation de température $\Delta T$ sous l'effet d'un éclairement donné, modulé par le taux de variation relative de la grandeur électrique mesurée G avec la température, soit $\Delta T.dG/G.dT$. Pour un bolomètre résistif de résistance R on s'intéresse à la grandeur $dR/R.dT$, autrement notée TCR.

Usuellement les longueurs d'onde infrarouge intéressantes sont voisines de 4 micromètres ou 10 micromètres pour les applications terrestres par suite de l'existence de fenêtres de transmission liées à la nature de l'atmosphère. Les détecteurs unitaires ont des dimensions latérales (dans le plan de l'image) minimales de quelques longueurs d'onde, soit quelques dizaines de micromètres pour les dispositifs adaptés à la bande 8 à 12 $\mu$m. De tels dispositifs sont alors appelés "microbolomètres".

Par nature, contrairement à la plupart des détecteurs quantiques infrarouges qui nécessitent un refroidissement, un détecteur de ce type est susceptible de fonctionner à température ambiante, pourvu qu'on sache discriminer l'échauffement dû au rayonnement incident (le signal) des diverses sources de bruit (thermique, électrique, ....) ambiantes. Cette fonction est du ressort des circuits associés et de leur mise en oeuvre. Leurs performances ultimes dépendent de quelques paramètres "technologiques", qui sont explicités dans la description.

L'observation de scènes en rayonnement infrarouge basée sur la microbolométrie se pratique avantageusement à l'aide de matrices (ou rétines) de NxM points bolométriques unitaires (pixels), associés individuellement à des circuits qui génèrent les stimuli de fonctionnement et traitent le signal électrique résultant. Ces circuits sont avantageusement installés directement, en assemblage "monolithique" ou "hybride", en dessous du plan matriciel des microbolomètres. Ils sont appelés par la suite "circuit de lecture". Une telle matrice est montée derrière une optique adéquate qui y focalise l'image infrarouge de la scène observée. "L'image thermique" résultante est convertie en signaux électriquement manipulables par les circuits associés.

La puissance de rayonnement infrarouge effectivement utilisée par unité de surface pour élever la température d'un bolomètre unitaire est égale à Pi.Ar. Fr : Pi étant la puissance incidente sur la surface totale d'un pixel, Ar l'absorption relative dans la surface utile du pixel, Fr le facteur de remplissage (surface utile/surface totale). La température T de la partie utile (variable en température) observable à l'équilibre, c'est-à-dire au bout d'un temps suffisamment long sous éclairement constant, est égale à Rth.Pi.Ar.Fr ; Rth étant la résistance thermique globale entre la zone sensible (utile) du bolomètre et son environnement. Les pertes thermiques pour des dispositifs montés sous vide (convection négligeable) sont largement dominées par la conduction le long des parties mécaniques qui relient le détecteur à son support (circuit de lecture).

Une variation instantanée de niveau d'éclairement sur le pixel considéré se traduit par une variation de température $\Delta T$ atteinte au bout de typiquement $3\tau$, (établissement à 95 % de la nouvelle valeur d'équilibre) avec $\tau$ = Rth.Cth : Cth étant la capacité thermique de la partie sensible.

Afin d'illustrer l'incidence des diverses grandeurs technologiques caractérisant le bolomètre sur les performances finales d'un point élémentaire, on peut considérer (entre autres arrangements possibles) le cas d'un bolomètre résistif polarisé en continu sous une tension de polarisation Vpol (on s'intéresse à la variation de courant sous l'effet d'une variation d'éclairement) et dont la lecture utilise un mode "choppé", c'est-à-dire la projection alternativement de la scène à observer et d'une température uniforme et constante de référence (telle l'image de la pale d'un "chopper"). La "prise de vue" se fait en projetant un élément de scène sur le bolomètre (point image) à t=0. Après un temps de montée à l'équilibre thermique (typiquement $3\tau$), on intègre le courant traversant le bolomètre pendant un temps t sous forme d'une charge Q = t.Vpol/R. Ensuite une image à température uniforme de référence est projetée sur le bolomètre (pale du chopper) et de nouveau après $3\tau$ (nouvel équilibre de température) le courant est intégré de la même façon et comparé par des moyens électroniques adéquats au signal précédent afin de quantifier l'élévation de température de l'élément, donc l'éclairement relatif reçu. On montre que, dans ce cas de mise en oeuvre, la puissance équivalente de bruit (NEP), égale à la plus petite puissance infrarouge détectable par le dispositif, s'exprime par :

$$NEP = (1/Ar.Fr.Rth).(1/|TCR|).(q/Q)^{1/2}.(2ut/Vpol)^{1/2}$$

où ut=kT/q, soit 25 mV à température ambiante. Cette relation est valide moyennant l'hypothèse que le bruit dans le bolomètre est "blanc", c'est-à-dire indépendant de la fréquence, car lié uniquement à la résistance R0 du bolomètre.

On voit donc que la puissance équivalente de bruit est d'autant plus faible (le détecteur d'autant plus performant) que l'absorption relative est élevée, tout comme le taux de remplissage et la résistance thermique des supports, ainsi que le coefficient de température TCR. En lecture, la charge intégrable mérite d'être aussi élevée que possible, comme la tension de polarisation. Ce dernier paramètre est généralement limité par l'augmentation de divers facteurs de bruit, en particulier dans le bolomètre lui-même, lorsque le champ dans la structure augmente. La tenue en tension du dispositif sans bruit excessif est donc une qualité essentielle.

La capacité thermique définit par ailleurs la vitesse de réponse du bolomètre, à ce titre c'est aussi un paramètre technologique important car il définit, à travers le produit Rth.Cth, la fréquence maximum de lecture du pixel (fm=1/6τ dans l'exemple considéré si t<<τ).

Deux exemples de réalisation de l'art antérieur sont décrits dans les brevets US-A-5 021 663 et US-A-5 367 167.

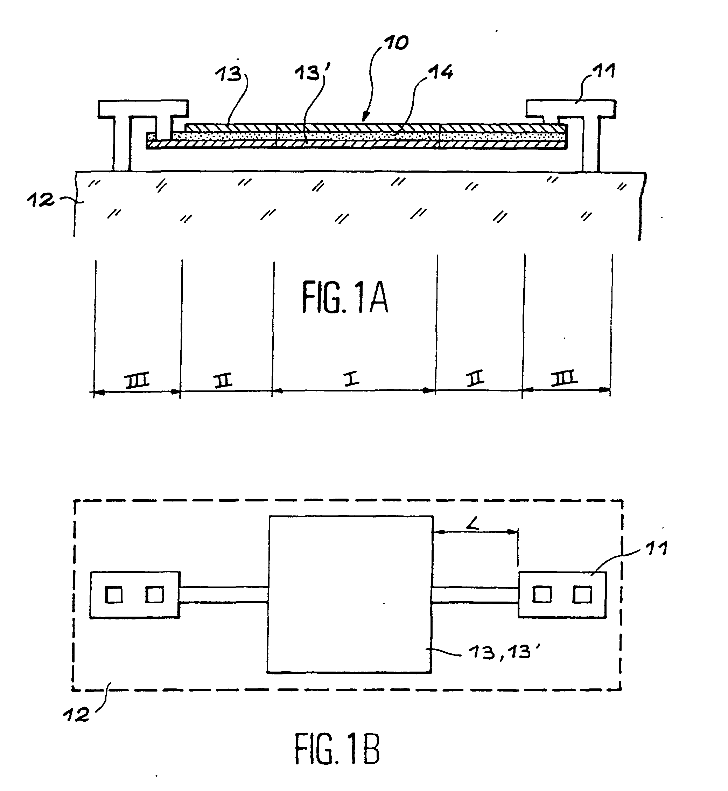

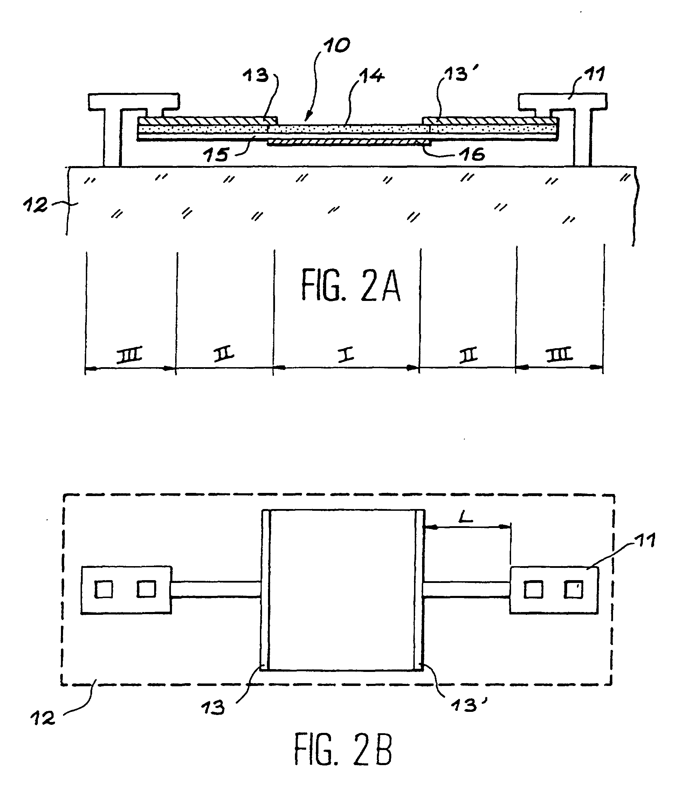

La figure 1 schématise le concept développé dans la première référence, la figure 2 celui développé dans la seconde. Typiquement un microbolomètre unitaire peut se subdiviser en trois parties principales : le coeur même du dispositif, dont la température varie avec l'éclairement (zone I sur les figures 1 et 2). Ce coeur est suspendu à l'aide des supports (zone II). Enfin, les zones III maintiennent l'ensemble.

La disposition et conformation de détail des différentes parties I, II et III représentées sous forme linéaire pour simplifier la description peut en particulier être adaptée à un matriçage suivant deux dimensions, afin de réaliser, avec une bonne compacité, des rétines photosensibles pour l'imagerie. Le caractère "suspendu" provient de la nécessité d'un isolement thermique, représenté par la grandeur Rth, très élevé entre le microbolomètre et son environnement.

Un microbolomètre unitaire se présente typiquement sous la forme d'un élément 10 sensible à la température (zone centrale I), supportée par au moins un élément de support (zone II), plus généralement deux, qui joue(nt) trois rôles :

- supporter mécaniquement la zone I ;
- connecter électriquement les bornes du microbolomètre aux zones III ;
- isoler thermiquement la partie sensible 10 des zones III.

Les zones III ont pour fonction de :

- connecter électriquement et mécaniquement l'ensemble I et II sur le support sous-jacent 12 ;
- positionner en altitude le plan du bolomètre, lorsqu'une couche réfléchissante est disposée en surface du substrat pour améliorer l'absorption infrarouge (paramètre Ar).

Sur les figures 1 et 2 le matériau bolométrique est référencé 14. Sur la figure 2 on a, de plus, une couche isolante électrique 15 et une couche conductrice "absorbeur" 16.

Il est, en effet, nécessaire de prévoir une structure dédiée ou intégrée pour assurer une absorption optique Ar dans le bolomètre aussi proche que possible de 1. Cet objectif est atteint d'après les lois de l'électromagnétisme lorsque la résistance de couche équivalente (toutes couches mises en parallèle) du microbolomètre est égale à 377 Ω/carré (absorption non sélective en longueur d'onde λ), et si on prend la précaution de placer un miroir (réflecteur) à une distance λ/4 sous le plan du microbolomètre pour renvoyer le rayon, transmis à travers l'ensemble flottant, vers le microbolomètre, en phase avec le rayon incident, compte tenu de la rotation de phase π à la réflexion métallique. Typiquement ce réflecteur, non représenté sur les figures 1 et 2, est disposé en surface du substrat/circuit de lecture 12. On veille à construire par des moyens technologiques adéquats des connexions 11 de hauteur appropriée pour maintenir rigidement le plan du bolomètre au voisinage de la distance spécifiée. Cette disposition conduit à un dispositif sélectif en longueur d'onde (maximum d'absorption à λ).

Comme déjà évoqué, le circuit de lecture 12, ordinairement réalisé sur un substrat en silicium suivant les techniques usuelles de la micro-électronique, est avantageusement disposé en dessous du bolomètre, en particulier dans le cas de structures matricielles de NxM points. Son rôle est d'une part de fournir les stimuli de polarisation au microbolomètre (application d'une tension ou d'un courant entre deux électrodes 13, 13'), d'autre part de mesurer les variations de caractéristiques induites par l'échauffement du bolomètre sous l'effet de l'éclairement infrarouge. L'ensemble du dispositif est monté sous vide, ou sous faible pression, pour éviter les pertes thermiques convectives, dans un boîtier étanche comportant une fenêtre optique en face avant et des connexions électriques vers l'électronique périphérique.

Dans tous les cas de construction, la zone I doit présenter une capacité thermique Cth aussi faible que possible, ce qui s'obtient en limitant le nombre de couches empilées dans cette zone à l'indispensable, leur épaisseur au minimum fonctionnel, et en choisissant si possible des matériaux à faible capacité calorifique spécifique Cp. La zone II doit présenter une résistance thermique Rth maximum, une résistance électrique négligeable devant celle de la zone I, et une capacité thermique faible (dans la mesure où elle constitue un "puits thermique" pour la zone I qu'on veut voir varier en température). Les zones III doivent assurer la continuité électrique entre les zones II et le substrat 12, c'est-à-dire une résistance électrique négligeable et une résistance mécanique suffisante pour maintenir en position l'ensemble flottant I + II.

La zone I comporte essentiellement l'élément 10 sensible à la température. Elle comprend typiquement deux électrodes conductrices 13 et 13' en contact avec un matériau "bolométrique" dont la résistance ou une autre caractéristique électrique varie avec la température.

Ces électrodes peuvent être parallèles au plan du substrat, en dessus et en dessous du matériau bolométrique qui est pris en sandwich. Cette configuration est illustrée par la figure 1. Selon ce premier concept, le courant résultant des stimuli imposés par le circuit de lecture traverse la structure perpendiculairement au plan du dispositif. Dans ce cas ces électrodes sont "pleines", c'est-à-dire occupent la totalité ou la plus grande partie de la surface de la zone I. Le matériau bolométrique peut être du silicium amorphe légèrement dopé n ou p, ou tout matériau dont la conductance, ou la susceptibilité diélectrique, ou la polarisation (puisque la configuration est clairement celle d'un condensateur) varie avec la température, par exemple au voisinage de la température ambiante.

Dans cette première configuration la résistance de couche globale pour optimiser le couplage optique (absorption Ar) est obtenue en ajustant celle des deux électrodes 13 et 13' au voisinage de 750 $\Omega$ /carré, puisqu'on a deux conducteurs en parallèle au sens optique.

Dans une autre configuration, illustrée par la figure 2, les électrodes 13 et 13' sont coplanaires et constituent de simples contacts latéraux, situés le long de deux arêtes opposées de la zone I et n'occupent typiquement qu'une faible partie de cette zone. Le courant dans la structure circule alors parallèlement au plan du dispositif. Cette deuxième configuration est mieux adaptée à la mise en oeuvre du silicium amorphe légèrement dopé n ou p comme matériau bolométrique car les électrodes sont, par construction, beaucoup plus éloignées. Cependant le couplage optique (Ar) ne peut être obtenu avec le silicium amorphe seul, dont la résistivité est beaucoup trop élevée. Ce couplage optique est alors obtenu en ajoutant une couche conductrice 16 spécifique de 377 $\Omega$/carré, isolée électriquement du corps de la zone I par une couche diélectrique 15.

Le concept illustré sur la figure 1 (US-A-5 021 663) présente les inconvénients suivants :

- Domaine d'application limité aux matériaux de forte résistivité, typiquement > $5.10^5$ $\Omega$cm pour procurer une résistance Ro de l'ordre du M$\Omega$ (0,1 $\mu$m de matériau thermosensible, surface 50 $\mu$m $\times$ 50 $\mu$m). Il en résulte, au moins dans le cas du silicium amorphe, des difficultés certaines de contrôle de procédé d'élaboration.

- Les structures de ce type présentent en général, au-delà de quelques centaines de millivolts de polarisation, des caractéristiques tension-courant non linéaires, voire fortement non linéaires, car l'épaisseur de la couche thermosensible doit être faible (submicronique) pour limiter la capacité thermique de l'ensemble. Ces faibles épaisseurs s'accompagnent ordinairement de phénomènes de conduction dominés notamment par les interfaces, typiquement bruyante et non linéaire. Cette caractéristique liée au très faible espacement des deux électrodes est préjudiciable aux performances d'imagerie de la rétine. Dans certaines conditions, des matériaux comme le silicium amorphe dopé ou des oxydes de vanadium peuvent présenter une linéarité acceptable, mais seulement aux faibles tensions de polarisation Vpol, ce qui tend à limiter les performances en termes de rapport signal / bruit, par affaiblissement du signal.

- Le bruit électrique de telles structures tend ordinairement à augmenter rapidement quand la tension de polarisation augmente ; par apparition d'autres mécanismes de bruit que le "bruit blanc" lié à la valeur de la résistance. Il en résulte que, même si on admet de travailler en zone non linéaire (sous forte tension pour augmenter le signal), le rapport signal/ bruit se détériore par augmentation du bruit.

- La réalisation est complexe (cinq niveaux de masquage au moins) car les électrodes 13 et 13' sont indépendantes, ce qui nécessite, quelles que soient les astuces d'assemblage, un niveau lithographique et des opérations associées pour réaliser les reprises de contact dans les zones III, respectivement sur 13 et 13'. D'autre part, au moins trois couches sont nécessaires pour réaliser la structure (électrode 13/matériau bolométrique/électrode 13'), d'où un nombre d'opérations de construction élevé, c'est-à-dire finalement un coût élevé (nombre d'opérations /rendement).

- Certains procédés présentent des caractéristiques critiques vitales, qui jouent sur le potentiel de rendement, par rapport à la fonctionnalité du dispositif : gravure des connexions situées dans les zones III, gravure de l'électrode 13', gravure périphérique de réticulation, intégrité des couches très fines prises en sandwich entre deux conducteurs non équipotentiels. Toutes ces caractéristiques sont potentiellement la source de fuites électriques entre électrodes, elles-mêmes sources de perturbations du signal (dispersions de niveau en structure matricielle) ou/et de bruit excédentaire.

- La fonction absorbeur infrarouge nécessite de réaliser deux couches de métal avec des résistances de couche de 750 Ω/carré, difficile à réaliser- et contrôler avec les métaux usuels, qui doivent par ailleurs présenter de bonnes caractéristiques de contact sur le matériau bolométrique. Le nitrure de titane (TiN) par exemple présente des résistivités élevées, 100 à 300 μΩcm usuellement suivant le procédé utilisé. Les épaisseurs requises vont de 13 à 40 Angström suivant la résistivité, et beaucoup moins avec les métaux usuels (Titane, Chrome...).
- Le dessin des zones d'interconnexion III occupe une surface relativement importante (deux vias+gardes et espaces divers) au détriment du facteur de remplissage Fr.

Le concept représenté sur la figure 2 (US-A-5 367 167) présente les inconvénients suivants :

- L'espacement élevé des électrodes du bolomètre, égal pratiquement au pas de répétition en structure matricielle, à épaisseur constante de matériau thermosensible (cette épaisseur est dictée par la contrainte sur Cth, c'est-à-dire minimum) implique une résistivité de ce dernier relativement faible pour assurer un niveau de résistance R0 adapté au couplage avec le circuit de lecture. Dans le cas du silicium amorphe, cela signifie un coefficient dR/RdT relativement faible. Cette approche est donc limitée en performances.
- La fonction absorbeur infrarouge nécessite, du fait de l'espacement très élevé entre les deux électrodes, une couche métallique sur toute la surface sensible, doublée d'une couche d'isolement diélectrique pour éviter le court-circuit avec les électrodes actives. L'épaisseur totale résultante de matériaux empilés est élevée (1500 à 2500 Angström de matières diverses), d'où une capacité thermique importante de la zone sensible.
- La statistique d'isolement (c'est-à-dire l'intégrité physique) de la couche de passivation (nécessairement très fine) entre absorbeur infrarouge et matériau sensible à la température, définit le rendement fonctionnel des dispositifs. Le dépôt de cette couche est donc une étape critique.
- La réalisation est complexe (six niveaux de masquage).
- Les interconnexions vers le circuit de lecture nécessitent une surface non négligeable (deux vias + un espace entre connexions). Le taux de remplissage Fr en est diminué d'autant.

Par rapport aux bolomètres résistifs actuels, qui ne présentent pas une relation courant/tension linéaire, à forte tension, et naturellement bruyants (dispositifs à électrodes parallèles) ou comportent, en plus de leurs électrodes, une couche métallique dans un autre plan pour assurer la fonction d'absorption des rayonnements (dispositifs à électrodes coplanaires), l'invention a pour objet un détecteur infrarouge de type bolomètre résistif à éléments conducteurs coplanaires qui permette d'assurer la fonction d'électrodes et l'absorption des rayonnements tout en conservant la linéarité de la relation courant/tension et un faible niveau de bruit même à forte tension.

De plus cette invention permet la mise en oeuvre de matériaux bolométriques plus performants (plus résistifs) suivant un assemblage technologique plus simple.

Exposé de l'invention

La présente invention concerne un détecteur infrarouge comprenant :

- une partie sensible comportant :

  - un élément sensible comportant une couche de matériau dont la résistivité varie avec la température,
  - des éléments conducteurs permettant d'assurer les fonctions d'électrodes dudit détecteur et d'absorbeur infrarouge ;

- au moins un élément de support de la partie sensible apte à positionner ladite partie sensible, à la relier électriquement à un circuit de lecture et à l'isoler thermiquement du reste de la structure ;

caractérisé en ce que tous les éléments conducteurs sont disposés sur la même face de la couche de matériau sensible à la température.

Selon un premier mode de réalisation les éléments conducteurs comportent deux électrodes interdigitées réalisant simultanément les fonctions d'électrodes et d'absorbeurs, ces électrodes étant reliées au circuit de lecture.

Selon un deuxième mode de réalisation les éléments conducteurs comportent deux électrodes d'un premier type reliées au circuit de lecture et au moins une électrode d'un second type porté à un potentiel flottant, l'électrode du second type assurant uniquement la fonction d'absorbeur et les électrodes du premier type assurant simultanément les fonctions d'électrodes et d'absorbeur.

Avantageusement au moins deux éléments conducteurs assurent la connexion électrique vers le circuit de lecture.

Selon une première variante ladite face de la couche de matériau sensible est la face inférieure, les éléments conducteurs étant disposés sous ladite couche.

Selon une seconde variante ladite face de la couche de matériau sensible est la face supérieure, les éléments conducteurs étant disposés sur ladite couche.

Selon une troisième variante, les éléments conducteurs sont situés entre deux couches de matériau sensible, c'est-à-dire en contact avec la face supérieure d'une première couche et la face inférieure d'une seconde couche de matériau sensible.

Avantageusement le matériau sensible à la température est du silicium amorphe dopé. Il peut être également un oxyde de vanadium.

Avantageusement l'espace libre défini entre les éléments conducteurs est constitué uniquement de matériau sensible à la température.

Avantageusement un réflecteur est prévu en surface du substrat supportant le circuit de lecture, et situé à $\lambda/4$ sous le plan de l'élément sensible, $\lambda$ étant la longueur d'onde du rayonnement R pour laquelle le bolomètre sera préférentiellement sensible.

Avantageusement le motif des éléments conducteurs est répété suivant un pas compris typiquement entre $\lambda$ et $\lambda/2$ pour obtenir une absorption moyenne supérieure à 90 % ; par exemple pour la détection dans la bande 8-12 $\mu$m, le pas d'électrode est inférieur ou égal à 8 micromètres, pour éviter l'effet de coupure des longueurs d'ondes « courtes » (8 à 10 $\mu$m) et supérieur ou égal à 5 $\mu$m pour éviter les effets de polarisation.

Avantageusement chaque élément support comporte au moins un pilier de connexion et au moins un bras d'isolement thermique.

L'invention concerne également un détecteur constitué d'un ensemble de détecteurs unitaires tels que définis ci-dessus.

L'invention concerne également un procédé de fabrication d'un détecteur infrarouge, caractérisé en ce qu'en partant d'un circuit de lecture déjà achevé à partir d'un substrat, il comporte les étapes suivantes :

a) formation d'une couche sacrificielle ;

b) dépôt d'au moins une couche conductrice pour la réalisation des éléments conducteurs ;

c) réalisation d'au moins une ouverture de contact vers le circuit de lecture par gravure localisée de la couche conductrice et de la couche sacrificielle ;

d) dépôt d'au moins un matériau conducteur et gravure de ce dernier de façon à assurer la liaison électrique entre les éléments conducteurs et le circuit de lecture, le motif ainsi réalisé formant le pilier du support ;

e) gravure de la couche conductrice déposée à l'étape b) de façon à définir les motifs des éléments conducteurs ;

f) dépôt sur l'ensemble, de la couche de matériau sensible à la température et gravure des différentes couches disposées au-dessus de la couche sacrificielle de façon à définir l'élément sensible et le bras du support ;

g) gravure de la couche sacrificielle de façon à libérer la partie sensible, et le pilier.

L'ordre des étapes précédentes peut bien entendu être modifié, en particulier selon un autre mode de réalisation, l'étape f) de dépôt de matériau sensible peut être réalisée avant l'étape b), le matériau sensible étant alors gravé à l'étape c).

Selon encore un autre mode de réalisation, le matériau sensible est déposé selon une première couche avant l'étape b) et en une deuxième couche à l'étape f), la première couche de matériau sensible étant alors gravée à l'étape c).

Par ailleurs, suivant le matériau de la couche conductrice de l'étape b), l'étape d) peut être réalisée avant ou après cette étape b).

On entend par pilier tout élément apte à supporter, à partir du bras du support, la partie sensible, quelle que soit sa géométrie.

Selon un mode avantageux, on réalise préalablement à l'étape a), le dépôt et la gravure d'une couche métallique pour former un réflecteur.

Selon un mode avantageux de réalisation la couche sacrificielle est une couche de polyimide à laquelle on a fait subir un recuit.

Selon un autre mode avantageux de réalisation, la couche conductrice de l'étape b) est une bicouche de nitrure de titane et d'aluminium, le matériau conducteur de l'étape d) étant déposé alors après réalisation des étapes b) et c), ce matériau conducteur et l'aluminium étant ensuite gravés de la même façon à l'étape d).

Selon un autre mode avantageux, le matériau conducteur de l'étape d) est un multicouche dont au moins une des couches est formée par LPCVD.

Selon un mode de réalisation, les éléments conducteurs présentent une première et une deuxième faces, le matériau sensible étant en contact avec l'une des faces desdits éléments, l'autre face est mise en contact avec une couche de matériau passif.

Selon encore un autre mode de réalisation, une couche de matériau passif est également déposée sur la ou les faces du matériau sensible, non en contact avec les éléments conducteurs.

Enfin, selon un mode avantageux, le matériau passif est choisi parmi l'oxyde de silicium, le nitrure de silicium et le silicium amorphe.

Les avantages principaux du détecteur de l'invention sont les suivants :

- Cette réalisation présente une simplicité maximale, donc un potentiel de rendement technologique maximum pour deux raisons essentielles :

  - le nombre de couches et donc de niveaux lithographiques pour en définir les contours est minimum,
  - la présence d'une couche conductrice unique (dispositif à électrodes coplanaires sans contre-couche métallique) efface la criticité technologique de tous les matériaux et procédés évoqués précédemment.

- La capacité thermique totale Cth de la partie sensible est minimum grâce à la mise en oeuvre (dans la version la plus dépouillée) nécessaire de deux couches superposées seulement dans la zone sensible : une couche sensible à la température, essentiellement continue, et une couche conductrice n'occupant typiquement qu'une partie de la surface de cette zone.
- Surtout, il est possible simplement à l'aide du dessin des motifs conducteurs de la zone sensible, d'améliorer les performances du détecteur par rapport à l'art antérieur, par l'emploi de matériaux plus résistifs (à TCR plus élevé dans le cas du silicium amorphe), ou d'ajuster la résistance Ro du détecteur pour un matériau de résistivité donnée, ce qui revient également à améliorer le dispositif.

Une première façon de réaliser ces motifs conducteurs consiste à définir deux électrodes en forme de peignes interdigités, couvrant l'essentiel de la surface de la zone sensible.

- Le coefficient de variation en température TCR peut alors être optimisé, tout en restant assorti d'une caractéristique courant-tension linéaire parce qu'intrinsèque aux dispositifs à électrodes coplanaires. Cette optimisation peut être obtenue par la réduction de l'espace entre les deux électrodes, moyennant certaines précautions relativement à l'absorption optique, comme exposé plus loin, afin d'autoriser la mise en oeuvre de matériaux plus résistifs (à plus fort TCR dans le cas du silicium amorphe), à R0 constant (imposé par Q à Vpol constant). Une autre façon d'exploiter cet arrangement d'électrodes est d'augmenter la tension de polarisation Vpol, à dessin d'électrodes, épaisseur de matériau sensible et Q constants, en augmentant d'autant la résistance R0, c'est-à-dire en utilisant un matériau plus résistif (par exemple par une action adéquate sur le dopage du silicium amorphe), ce qui tend à améliorer TCR dans le cas du silicium amorphe.

Une seconde façon de réaliser les électrodes métalliques consiste à ne connecter que deux éléments conducteurs n'occupant qu'une partie de la surface de la zone sensible. Ces deux éléments constituent les électrodes proprement dites du dispositif. D'autres éléments conducteurs sont laissés libres de flotter électriquement de part et d'autre de ces électrodes.

La résistance Ro vue entre les deux électrodes peut varier très sensiblement (typiquement d'un facteur > 60 à 600 pour une définition lithographique de 3 $\mu$m et 1 $\mu$m respectivement et une taille de détecteur de 50 $\times$ 50 $\mu$m) entre les diverses façons de réaliser ces motifs, à épaisseur et résistivité du matériau sensible constantes. Ce trait intrinsèque à l'invention offre un degré de liberté considérable au concepteur pour optimiser le couplage du détecteur au circuit de lecture, sans modifications technologiques, ni ajustement de la résistivité du matériau sensible, éventuellement inaccessible.

- Accessoirement le facteur de remplissage est optimisé par la mise en oeuvre d'une méthode de connexion électrique et mécanique vers le circuit de lecture de faible encombrement, qui comporte un ou (plus généralement) deux piliers par point élémentaire (ou détecteur unitaire). Certains modes de réalisation permettent la réalisation de connexions à caractéristiques mécaniques améliorées par rapport à l'état de l'art, par disposition symétrique des couches. La conséquence est essentiellement une meilleure statistique de positionnement du plan sensible par rapport au réflecteur, donc une meilleure uniformité de réponse pour un ensemble de détecteurs.

Brève description des dessins

- les figures 1A et 1B illustrent un premier exemple de réalisation d'un détecteur de l'art antérieur, respectivement dans une vue parallèle au plan du substrat et dans une vue de dessus ;
- les figures 2A et 2B illustrent un second exemple de réalisation d'un détecteur de l'art antérieur, respectivement dans une vue parallèle au plan du substrat et dans une vue du dessus ;
- les figures 3A et 3B illustrent le dessin général du détecteur selon un premier mode de réalisation de l'invention, respectivement dans une vue parallèle au plan du substrat et dans une vue du dessus ;
- les figures 4A et 4B illustrent deux autres exemples de réalisation d'électrodes du détecteur de l'invention illustré sur la figure 3 ;
- les figures 5A et 5B illustrent un deuxième mode de réalisation du détecteur selon l'invention ;
- la figure 6 représente une simulation obtenue à partir des équations de Maxwell de l'absorption relative Ar en fonction du paramètre p/$\lambda$ (pas du motif/longueur d'onde) ;
- la figure 7 illustre les types de rayonnement et le champ électrique utilisés dans la simulation de la figure 6 ;
- les figures 8A, 9A, 10, 11A, 12A, 13, 14A, 15 et 16 illustrent différentes coupes de la structure formée par le détecteur de l'invention, au cours de la fabrication de celui-ci ;
- les figures 8B, 9B, 11B, 12B et 14B illustrent des vues de différents niveaux lithographiques du détecteur de l'invention, au cours de la fabrication de celui-ci.

Exposé détaillé de modes de réalisation

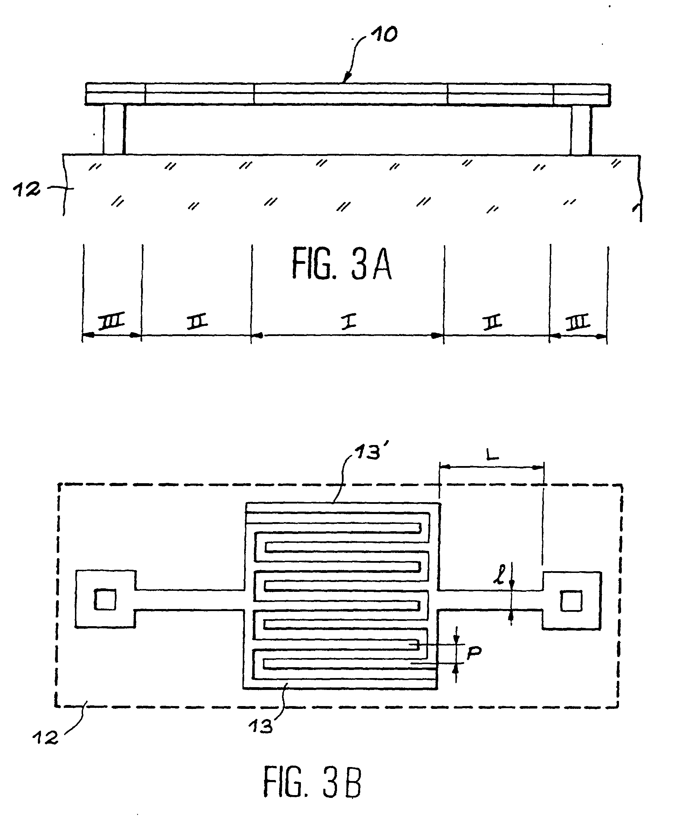

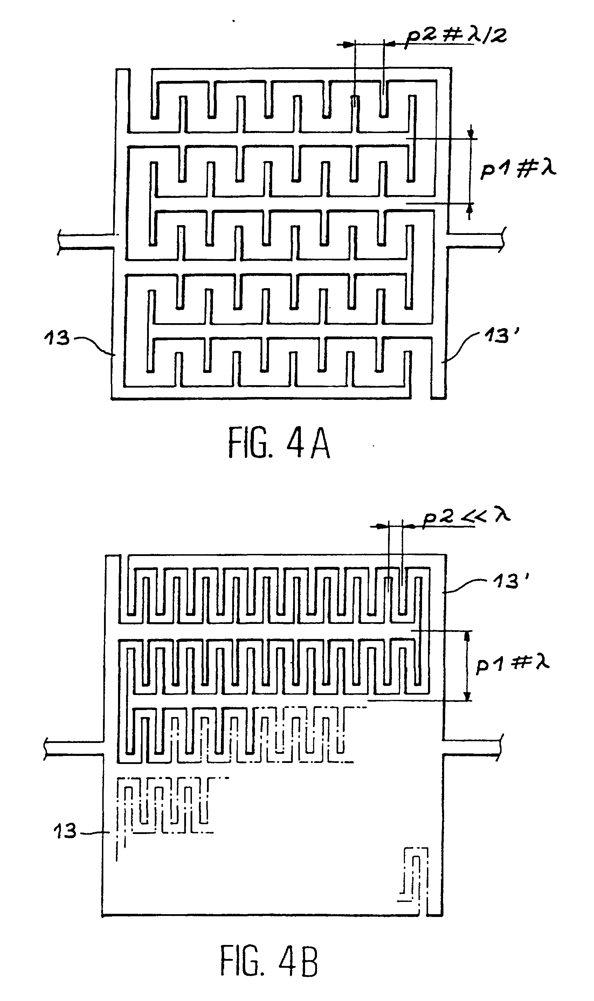

L'invention consiste en un dispositif réalisé à l'aide d'une seule couche conductrice dans laquelle sont définis, à l'aide d'un seul niveau lithographique, des motifs correspondant aux éléments conducteurs. Selon l'invention ces éléments conducteurs peuvent être réalisés de deux façon différentes. les figures 3 et 4 représentent un premier mode de réalisation des éléments conducteurs. Selon ce mode, ces éléments sont réalisés sous forme de deux peignes interdigités réalisant simultanément les fonctions d'électrodes du microbolomètre, d'absorbeur infrarouge et de connexion électrique vers le circuit de lecture. Cette structure s'applique particulièrement, mais pas exclusivement, à la mise en oeuvre du silicium amorphe faiblement dopé comme matériau sensible à la température.

De façon plus précise le dispositif de l'invention donné par la figure 3 comprend une zone I comportant deux électrodes conductrices 13 et 13' en forme de peignes interdigités en surface, ces peignes 13 et 13' peuvent avoir les formes illustrées sur les figures 3, 4 et 5.

La zone I de la partie sensible 10 est la zone sensible à la température. Elle comporte en outre une couche de matériau dit bolométrique, dont la résistivité varie avec la température. Cette couche peut être réalisée en silicium amorphe (a-Si:H) dopé n ou p.

Selon l'invention les deux électrodes conductrices 13 et 13' en forme de peignes interdigités, cumulent deux fonctions distinctes, contrairement aux dispositions de l'art antérieur : celle d'électrodes et celle d'absorption. Par ailleurs, dans ce mode de réalisation, on peut optimiser l'espace libre défini entre ces deux électrodes 13 et 13', qui peut être avantageusement constitué uniquement de matériau sensible à la température (suivant le mode réalisation le plus dépouillé). Il a avantageusement une longueur minimum et une largeur maximum, de façon à autoriser la mise en oeuvre du matériau de résistivité la plus élevée possible (à R0 constant) pour maximiser dR/RdT (la longueur et la largeur sont définies relativement au sens du passage du courant d'une électrode vers l'autre). Dans un point élémentaire de $50 \times 50\ \mu m^2$ par exemple, et pour une résolution lithographique de deux micromètres, il est possible, en simplifiant, de définir un espace de deux micromètres de longueur et $(12 \times 50)$ micromètres de largeur, soit une résistance globale de couche de 1/300 carré ; la résistance vue entre deux électrodes linéaires disposées sur deux arêtes opposées du point élémentaire équivalent de son côté à un carré. Le gain pour une lithographie de un micromètre de résolution est donc de 300 sur la résistivité du matériau à résistance R0 équivalente (valeur sous obscurité) du point élémentaire.

En outre l'absorption du rayonnement infrarouge reçu par la zone I de la partie sensible 10 est fonction de la résistance de couche équivalente dans cette zone I et de la présence ou non d'un réflecteur en surface du substrat 12. Il est judicieux, conformément à l'état de l'art, de prévoir un tel réflecteur pour renvoyer vers la zone sensible l'énergie qui traverse la zone I de la partie sensible 10. Dans ces conditions on obtient une absorption voisine de 100 % au voisinage de 10 micromètres de longueur d'onde, pour un espace voisin de 2.5 micromètres (quart d'onde) entre le réflecteur et le plan de l'élément sensible, et pour une résistance de couche voisine de 380 Ω/carré de cette même zone. L'analyse détaillée de ces effets optiques se trouve par exemple dans un article de K.C. Liddiard, Infrared Physics, vol. 34, N° 4, pages 379-387, 1993. Compte tenu de la résistivité élevée des matériaux usuels en bolométrie, la résistance de couche équivalente de la zone I de la partie sensible 10 est égale à celle de la (ou des) couche (s) conductrice(s) en parallèle qui la composent. L'épaisseur de cette (ces) couche(s) doit être minimale (optimisation de Cth de la zone I) et Rth des zones II, tout en restant technologiquement pratique, c'est-à-dire contrôlable et reproductible. Les électrodes en formes de peignes suivant l'invention jouent ce rôle d'absorbeur infrarouge en une seule couche, associée avantageusement à un seul niveau lithographique de définition.

Il convient d'optimiser le dessin des électrodes interdigitées pour obtenir le meilleur rendement optique possible.

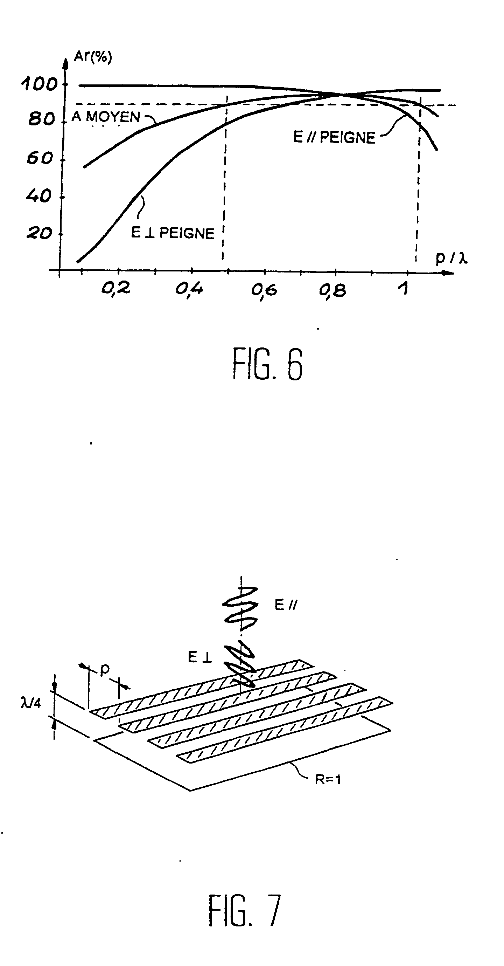

La figure 6 illustre une simulation effectuée à partir des équations de Maxwell, de l'absorption relative Ar en fonction du paramètre p/λ (pas de motif/longueur d'onde) d'un motif infini suivant les deux dimensions normales au rayon incident, constitué d'une alternance d'éléments conducteurs de largeur d, espacés de e (p=d+e). Ce calcul est effectué pour un rayonnement incident normal à la surface du bolomètre, dont le champ électrique est parallèle (E//) ou perpendiculaire (E⊥) à la grande dimension des éléments conducteurs, comme illustré sur la figure 7.

Ainsi sur cette figure 7, la simulation suppose d'une part la présence d'un réflecteur situé à λ/4 sous le plan du bolomètre et une valeur optimale de la résistance de couche équivalente du motif métallique $Rcarré_{éq.} \# 380\ \Omega/carré$.

On va, ci-dessous, considérer successivement-trois cas possibles :

*Premier cas :*

Le champ électrique du rayonnement incident est parallèle à la grande dimension des motifs (E//).

Lorsque p<<λ, le motif se comporte comme une couche continue de résistance carrée équivalente égale à $Rcarré_{éq.} = Rcarré_{métal} \cdot p/d$, et l'absorption est voisine de 100 %.

Lorsque p=λ l'absorption vaut encore à peu près 80 %, puis diminue rapidement au-delà par effet de diffraction.

*Second cas :*

Le champ électrique du rayonnement incident est perpendiculaire à la grande dimension des motifs (E⊥).

L'absorption relative est faible pour p<<λ (extinction par effet de polarisation), puis augmente rapidement avec p, lorsque p>λ/2, on obtient Ar>80% ; le maximum d'absorption est atteint à p=λ (effet de résonance dû à la cavité quart-d'onde).

*Cas général :*

L'orientation du champ électrique du rayonnement incident est aléatoire par rapport au motif des électrodes. L'absorption relative moyenne, A moyen, (efficace) adopte une valeur intermédiaire entre les deux premières courbes. Lorsque 0.5λ<p<λ, Ar>90%, l'optimum global efficace est situé vers 8 micromètres de pas pour maximiser l'absorption moyenne d'un rayonnement à 10 μm.

Il suffit donc que le motif des éléments conducteurs soit répété suivant un pas compris typiquement entre λ et λ/2 pour obtenir une absorption moyenne supérieure à 90%. Cependant dans le cas de la détection infrarouge dans la bande atmosphérique 8-12 micromètres, la diminution rapide d'absorption par effet de diffraction lorsque p>λ peut justifier un pas d'éléments : p≤8μm, pour éviter l'effet de coupure des longueurs d'ondes courtes (8 à 10 μm).

Le dessin des électrodes représenté sur la figure 3B, qui est un réseau simple de bandes, au pas compris entre cinq micromètres et huit micromètres est conforme à ce critère pour la détection entre 8 micromètres et 12 micromètres dans une surface sensible de 50μm × 50μm. On peut retenir la solution équilibrée d/e=1, c'est-à-dire des doigts de 2.5 micromètres ; espacés de 2.5 micromètres, jusqu'à des doigts de 4 micromètres espacés de 4 micromètres avec un résultat comparable en termes d'absorption au voisinage de 10 micromètres de longueur d'onde.

La résistance équivalente pour des électrodes dessinées au pas de 5 micromètres avec p/d=1 vaut environ Rcarré$_{bolo}$/200 quelle que soit la forme des interdigitations, Rcarré$_{bolo}$ étant la résistance de couche du matériau bolométrique. En particulier on obtient une valeur comparable, aux effets de pointe près, pour le dessin en forme de "poteau télégraphique" de la figure 4A. Un tel dessin ne présente pas davantage d'effet de polarisation.

Dans un but d'exploitation optimum du concept proposé, dans le détecteur de l'invention, d'électrodes coplanaires rapprochées, on peut typiquement descendre l'espace inter-électrodes vers 1 micromètre sans être gêné par la non-linéarité de la caractéristique courant/tension, jusqu'à quelques volts de polarisation (Vpol). Cependant la figure 6 montre qu'il est important d'éviter les motifs qui présentent un pas petit devant la longueur d'onde selon une direction seulement, car il en résulte un effet de polarisation.

La figure 4B présente un exemple de réalisation "d'électrodes en poteau télégraphique" conforme à ce critère, autorisant des pas de l'ordre de 2 micromètres ou moins, sans effet préjudiciable de polarisation. Dans une direction horizontale sur le schéma on réalise des "collecteurs" avec un pas p1 voisin ou un peu inférieur à λ de manière à assurer l'absorption des photons infrarouges à polarisation "horizontale", par rapport au dessin. Dans l'autre direction on peut avoir un pas p2 nettement plus petit, assurant l'absorption des photons infrarouges à polarisation "verticale". La résistance résultante Ro d'un bolomètre de 50 μm × 50 μm pour un pas p1 de 2 micromètres avec p1/d #1 entre les électrodes est de l'ordre de Rcarré$_{bolo}$/400 à 500. Des matériaux à TCR encore plus élevés sont alors utilisables à résistance R0 donnée.

Il convient en principe d'observer le même rapport d/e selon les deux directions si l'électrode est obtenue en une seule opération (une seule couche conductrice). Cependant l'affaiblissement de l'absorption lorsque Rcarré$_{éq}$. s'éloigne de la valeur optimale d'environ 380 Ω/carré est lent et on peut dans la pratique tolérer +/-40% de variation sans perdre plus de 10% sur l'absorption. Il est donc facile d'ajuster la répartition des zones conductrices et des espaces pour satisfaire au mieux les critères précités.

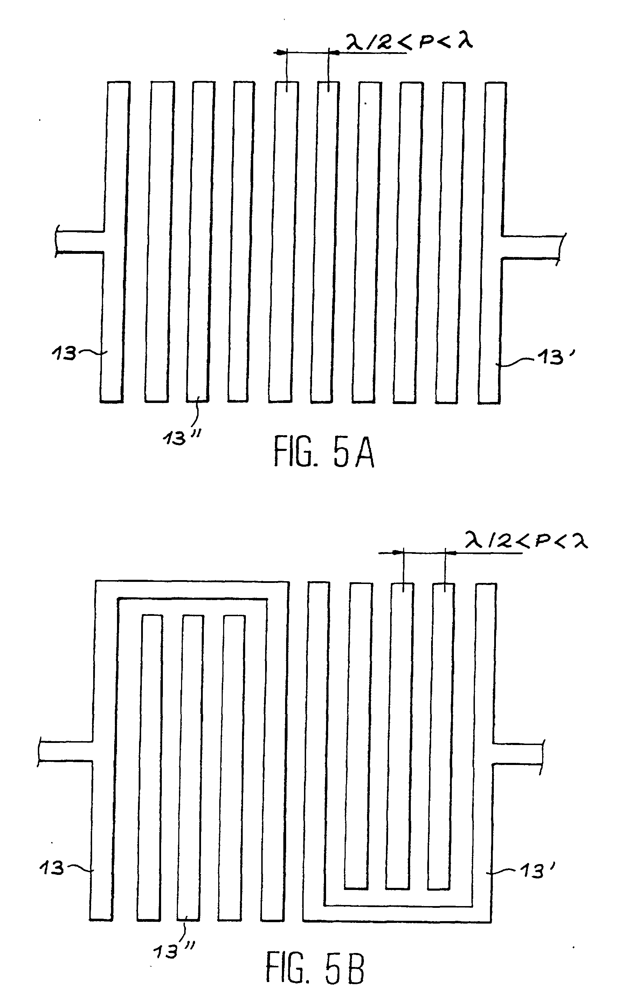

Les figures 5A et 5B représentent des exemples de deuxième mode de réalisation des éléments conducteurs de la partie sensible du détecteur. Ces éléments sont définis suivant une pluralité de motifs disjoints dont au moins deux sont connectés au circuit de lecture et constituent à proprement parler les électrodes 13 et 13', les autres motifs 13 " n'étant pas connectés. Sur la figure SA les motifs 13" sont des conducteurs rectilignes, dans cet exemple au nombre de huit, parallèles entre eux et parallèles aux électrodes 13 et 13'. Ces motifs sont séparés d'un pas p tel que : λ/2 < p < λ. Dans l'exemple de la figure 5B les électrodes 13 et 13' ont la forme d'un « U », dans lesquelles sont disposés les motifs 13" qui sont également des conducteurs rectilignes, parallèles aux deux branches extérieures du « U », l'espacement p entre ces conducteurs étant également : λ/2 < p < λ. Ainsi les électrodes 13 et 13' assurent comme dans le premier mode de réalisation la double fonction d'électrodes et d'absorbeur tandis que les éléments 13" n'ont que la fonction d'absorbeur. Ainsi toutes les caractéristiques concernant l'absorption des éléments conducteurs décrite précédemment s'applique également à ce mode de réalisation.

Ce deuxième mode de réalisation permet une plus grande souplesse d'ajustement de la résistance Ro du fait de la possibilité de connecter aux circuits de lecture deux éléments très éloignés comme dans la figure 5A ou très rapprochés comme dans le cas de la figure 5B. Ceci permet une optimisation du couplage avec le circuit de lecture.

Ainsi, selon ce deuxième mode de réalisation représenté par la figure 5A, il est possible de mettre en oeuvre dans des conditions optimales des matériaux relativement peu résistifs, tel par exemple le dioxyde de

vanadium $VO_2$, tout en conservant les avantages de simplicité technologique et d'immunité aux défauts des matériaux constituant le dispositif propre à l'invention. En effet il est nécessaire de viser une résistance Ro élevée (quelques M$\Omega$ typiquement) afin de limiter l'échauffement du détecteur sous l'effet des stimulis de lecture par effet Joule, et plus simplement la consommation globale du dispositif en fonctionnement.

La figure 5B et les variantes diverses que l'homme de l'art en déduira, permet de réaliser des résistances de valeurs intermédiaires suivant les objectifs d'optimisation envisagés. Les motifs non connectés s'équilibrent naturellement en fonctionnement à des potentiels intermédiaires entre les potentiels des électrodes connectées 13 et 13' (sans perturber les caractéristiques du détecteur) suivant le principe du pont diviseur.

Ainsi, le fait de réaliser, suivant l'invention, les fonctions absorbeur infrarouge et électrodes du matériau sensible en température à l'aide d'une seule couche conductrice, simplifie notablement le processus technologique d'une part, car un seul niveau lithographique, associé à une seule opération de gravure, est nécessaire. D'autre part une résistance de couche proche de 380 $\Omega$/carré est obtenue avec une épaisseur plus importante de matériau conducteur, sans augmentation de la masse totale, ce qui améliore la praticité du procédé de dépôt. En effet si l'absorbeur est réalisé à l'aide de deux couches continues en parallèle, suivant une possibilité de l'art antérieur, ces deux couches doivent présenter une résistance d'environ 750 $\Omega$/carré, ce qui nécessite des épaisseurs difficilement contrôlables avec des matériaux métalliques même relativement résistifs comme le nitrure de titane : on obtient 15 à 40 Angström typiquement par couche, en admettant une résistivité de 100 à 300 $\mu\Omega$cm, qui sont des valeurs typiques fonction du procédé de dépôt. De même suivant une autre version de l'art antérieur, qui nécessite une seule couche continue, il faut une épaisseur double (30 à 80A dans le cas du nitrure de titane), ce qui n'est pas très pratique dans la plupart des cas. Selon la solution proposée dans l'invention, il est nécessaire de déposer une épaisseur proche de ($\rho$/380).(p/d), c'est-à-dire de 60 à 160 Angström pour d=p/2, ou encore de 90 à 240 Angström pour d=p/3. Ces épaisseurs sont raisonnablement aisées à réaliser et contrôler, les valeurs p/d proposées étant à considérer comme typiques.

L'homme de l'art note aussi l'avantage des structures à électrodes coplanaires au niveau de l'immunité aux courts-circuits entre les deux électrodes. En effet les défauts ponctuels d'intégrité de la couche thermosensible ("pinholes") n'ont aucune conséquence dans une telle disposition. De plus, la présence d'une couche conductrice continue isolée électriquement du matériau thermosensible suivant certaines formes de l'art antérieur, rend sensible également le rendement de fabrication à la densité de défauts de cette couche d'isolement. Or cette couche d'isolement est inutile suivant l'invention. La configuration proposée dans l'invention est donc intrinsèquement robuste par rapport aux défauts des matériaux mis en oeuvre.

L'homme de l'art notera également l'avantage particulier offert par les formes de l'invention telles que représentées par la figure SA au niveau de l'immunité aux court-circuits entre électrodes. En effet un défaut aléatoire au niveau de la lithographie des zones conductrices mettra en général en court-circuit deux éléments flottants, sans court-circuiter les deux électrodes connectées. Il en résulte une modification de résistance Ro, mais le point élémentaire restera en général opérationnel.

Les zones II ont deux rôles principaux :

- supporter mécaniquement le corps du dispositif flottant 10 au-dessus du circuit de lecture ;
- connecter électriquement les électrodes réalisées dans la zone I jusqu'aux terminaux métalliques du circuit de lecture, solidaires du substrat 12.

Conformément à l'état de l'art, ces bras de support/isolation peuvent être avantageusement découpés dans l'assemblage de couches formant la partie centrale I, suivant un motif de longueur L et de largeur 1. L'épaisseur est par construction identique à celle de la zone I. La longueur de ces motifs doit être maximum, la largeur et l'épaisseur minimum afin de maximiser Rth.

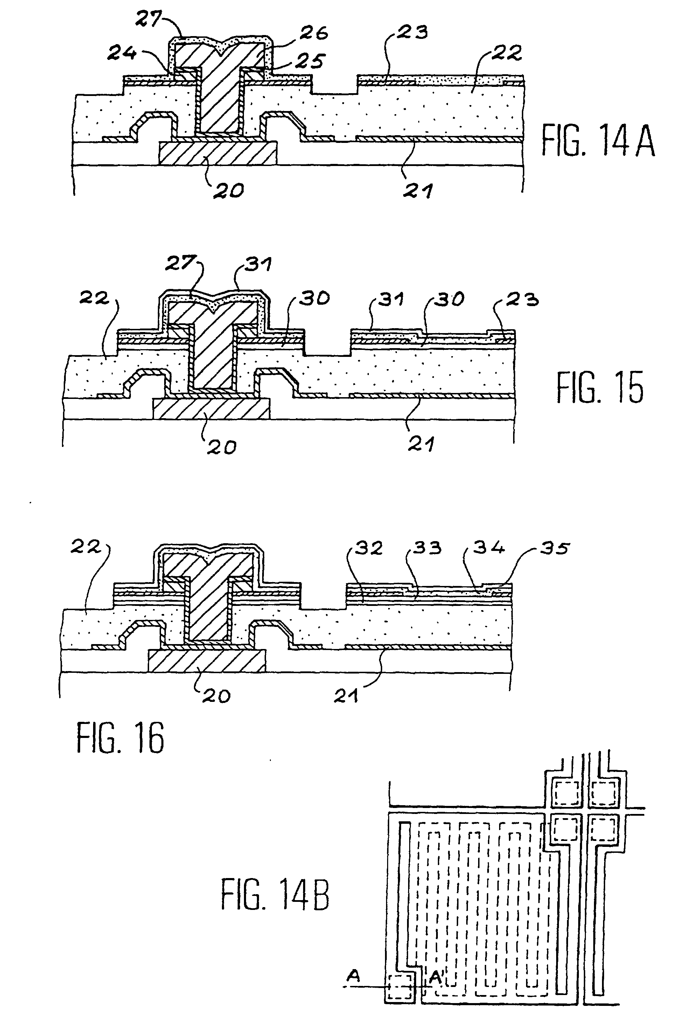

Cependant pour des raisons de rigidité mécanique, et surtout de déformations géométriques (dues à la libération des contraintes internes des différents matériaux constitutifs lorsque les structures sont libérées), on doit trouver un compromis raisonnable. En effet, il est nécessaire de contrôler l'espace entre le corps du bolomètre et le réflecteur pour bénéficier de l'effet quart-d'onde sur toute la surface du détecteur, et la moindre déformation des bras supports entraîne une variation de cet espace. Une découpe latérale de longueur L égale à un ou deux côtés d'un point élémentaire ou pixel représente un maximum au niveau mécanique, soit de 40 à 80 micromètres utiles pour un pixel de 50$\mu$m $\times$ 50$\mu$m. La largeur est typiquement de 1 à 3 micromètres. La figure 14 présente le dessin le plus aisé d'un pixel comportant deux bras d'isolement découpés suivant deux arêtes opposées. Chaque bras dans la version la plus simple se compose d'une couche conductrice et d'une couche de matériau sensible.

Les zones III, conformément à l'état de l'art, ont trois rôles principaux :

- supporter mécaniquement l'ensemble I+II ;
- connecter les zones II aux entrées électriques du circuit de lecture ;
- positionner en altitude l'ensemble du dispositif.

Suivant le mode préféré de réalisation, ces zones sont réalisés à l'aide de piliers d'encombrement réduit, ce qui nécessite simplement une ouverture dans la zone III. Le contact entre les électrodes conductrices 13 et 13', qui s'étend jusque sur la zone III est assuré essentiellement par un dépôt métallique, réalisé de préférence par LPCVD, typiquement de tungstène, mais d'autres matériaux déposés par LPCVD sont utilisables, tel le titane.

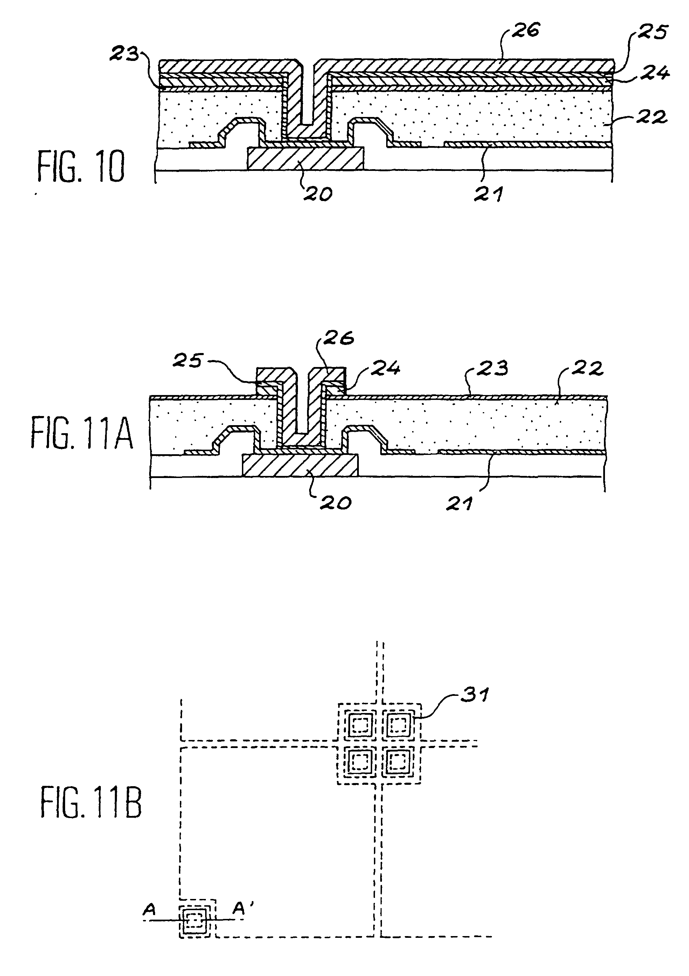

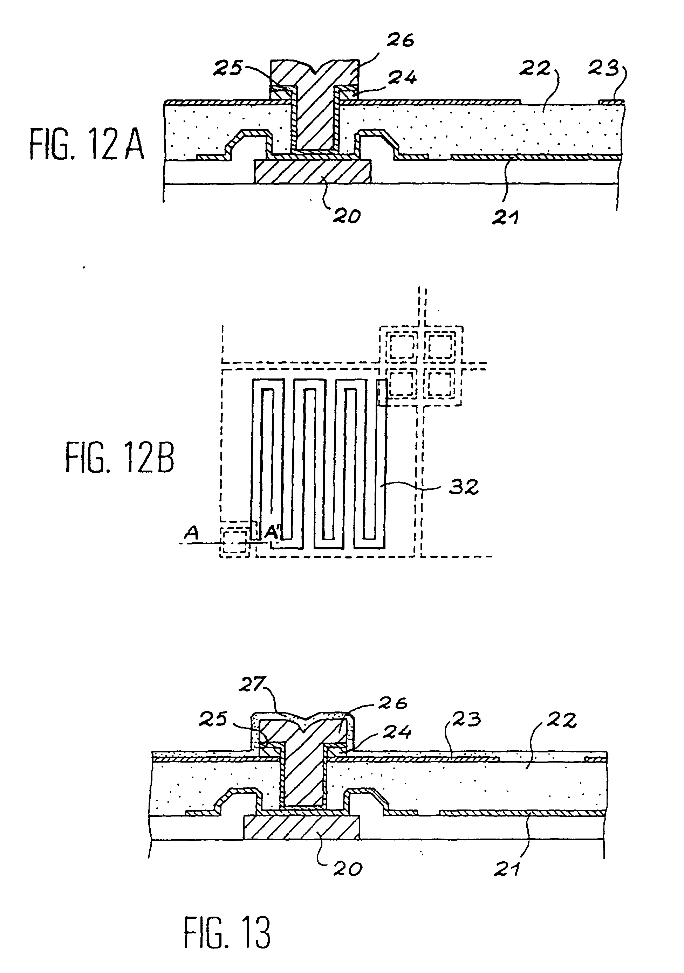

Les figures 11 et 12 représentent des cas de piliers de connexion suivant le mode de réalisation préféré utilisant un dépôt LPCVD. D'autres modes de réalisation sont possibles, par exemple un dépôt métallique par pulvérisation, mais dans ce cas il est nécessaire de prévoir des connexions de grand diamètre (plusieurs micromètres), présentant des flancs pentus. Il en résulte une perte de place plus importante (diminution du facteur de remplissage). Le corps du pilier est typiquement constitué de plusieurs couches destinées à réaliser les diverses fonctions de détail de la connexion, tel qu'explicité ci-dessous.

La configuration la plus intéressante consiste à réaliser le pilier par dépôt LPCVD d'un seul matériau suffisamment conducteur (métal réfractaire typiquement tel que titane) pour assurer simultanément toutes les contraintes technologiques du contact électrique entre l'électrode 13 et le plot métallique solidaire du substrat. Compte tenu de la résistance très élevée du bolomètre lui-même (typiquement 1MΩ à 100MΩ), il n'est pas nécessaire de prévoir des contacts de très faible résistance propre (Rc). Ainsi le titane ou le nitrure de titane par exemple sont directement adaptés à une telle réalisation car ils présentent les qualités requises par rapport aux autres contraintes d'assemblage technologique. La description détaillée qui suit suppose la mise en oeuvre (traditionnelle) de deux couches métalliques : titane, tungstène.

La hauteur du pilier définit l'espacement entre la partie sensible et le circuit sous-jacent. Cet espacement est conformément à l'état de l'art voisin de λ/4 pour centrer le maximum d'absorption au voisinage de λ si la surface du circuit est pourvue d'un réflecteur infrarouge.

Le procédé de fabrication du détecteur de type microbolomètre suivant l'invention se réalise typiquement à partir d'un circuit de lecture déjà achevé, obtenu lui-même suivant les techniques connues par exemple de la micro-électronique sur substrat de silicium S. Les éléments apparaissant en surface d'un tel circuit sont généralement à la fois les plots métalliques périphériques de montage (non représentés) pour l'intégration du produit final en boîtier sous vide, et les plots de liaison 20 de chaque point élémentaire du dispositif de détection vers les points correspondants du circuit de lecture. Ces plots 20, comme les plots de montage, sont réservés ordinairement au niveau du dernier niveau d'interconnexion métallique du circuit de lecture. Une telle couche métallique est ordinairement passivée à l'aide d'une couche isolante minérale. Cette couche minérale est gravée sur une partie de la surface des plots 20, ainsi que des plots de montage. Le procédé de fabrication du détecteur de l'invention s'entend donc à partir de la structure ainsi réalisée.

Les étapes non détaillées de l'enchaînement suivant font appel à des techniques éprouvées bien connues de l'homme de l'art.

Les étapes du procédé d'un exemple de fabrication s'ordonnent suivant la séquence suivante :

(Il est à noter que sur les vues de dessus décrites ci-dessous, les traits pleins correspondent aux contours du niveau lithographique considéré tandis que les traits pointillés représentent un ou plusieurs niveaux antérieurs).

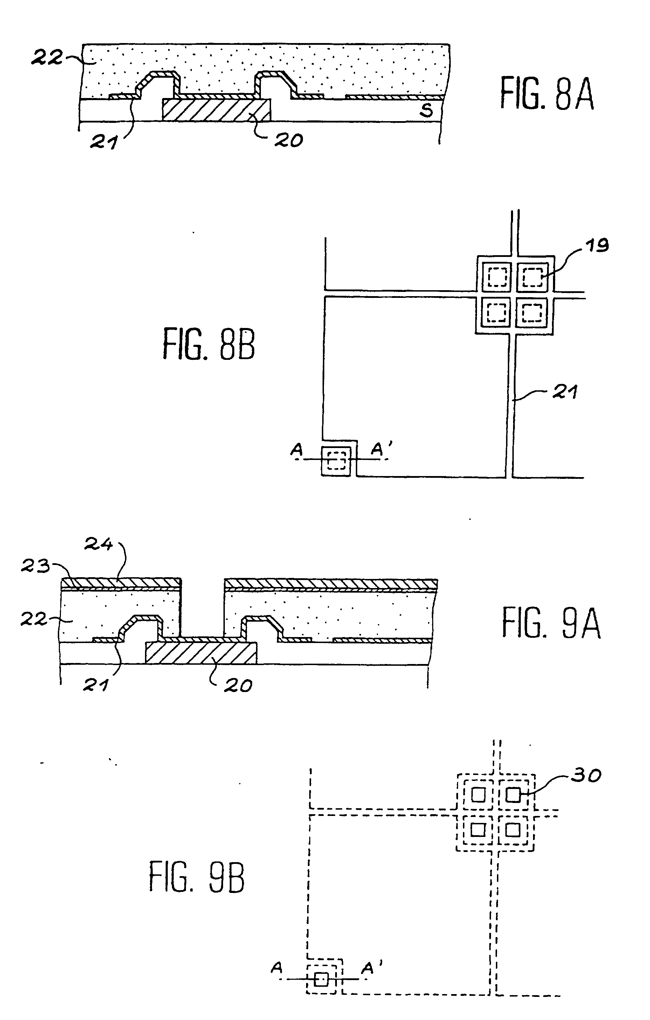

1/ Première étape (figure 8) : dépôt métallique pour réaliser le réflecteur (21).
200A à 500A de titane et 1000A d'aluminium, par exemple, déposés par pulvérisation suffisent.

2/ Seconde étape : définition à l'aide d'un premier niveau lithographique des motifs du réflecteur et gravure de ce dernier selon les techniques connues de l'homme de l'art.

3/ Troisième étape : étendage d'une couche de polyimide (22), et recuit de cette couche, à une température de l'ordre de 400 à 450°C
L'épaisseur après recuit vaut environ 2.5 micromètres en moyenne pour assurer l'effet cavité résonante, conformément à l'état de l'art (la topographie du circuit de lecture induit une dispersion d'épaisseur, peu critique). Ce recuit est nécessaire pour éviter la modification des propriétés du polyimide pendant la suite du procédé. La température maximale atteinte pendant ce recuit doit être au moins égale à la température maximale atteinte par la suite jusqu'à la réalisation du détecteur.

4/ Quatrième étape (figure 9) : dépôt, typiquement par pulvérisation réactive, d'une couche de nitrure de titane 23 et d'une couche d'aluminium 24.
Le nitrure de titane constitue les électrodes du bolomètre (car la couche d'aluminium est éliminée ultérieurement). Son épaisseur doit donc être adaptée à la fonction absorbeur optique, conformément à l'objet de l'invention. Le choix du nitrure de titane est avantageux pour plusieurs raisons : il forme des contacts de bonne qualité avec le silicium amorphe ; il est relativement facile à déposer en couches très minces ; il présente une résistivité plutôt élevée, et à la rigueur ajustable ; et, surtout, il est facile de graver très sélectivement une couche d'aluminium déposée au-dessus. Pour une résistivité typique de 130 à 140μΩcm, on dépose environ 75 Angström de nitrure de titane.

5/ Cinquième étape : masquage à l'aide d'un second niveau lithographique des ouvertures de contact vers le circuit de lecture, qu'on appelle "vias", et gravure de la couche d'aluminium, de la couche de nitrure de titane, et de la couche de polyimide jusqu'à la base de celle-ci selon les techniques connues de l'homme de l'art.

6/ Sixième étape (figure 10) : dépôt, typiquement par pulvérisation cathodique, de titane (25).

Le rôle du titane est d'assurer un contact électrique de bonne qualité entre l'aluminium du réflecteur d'une part et l'aluminium en surface du polyimide d'autre part et le matériau de remplissage des vias (tungstène).

7/ Septième étape : dépôt par LPCVD d'une couche 26 de 5000 Angström à 1 micromètre de tungstène selon les techniques connues de l'homme de l'art.

Une variante avantageuse de réalisation des métallisations consiste à déposer directement et uniquement du titane par LPCVD, en lieu et place des sixième et septième étapes. En effet la résistance des bolomètres est très grande devant la résistance propre du contact et du pilier de connexion ainsi réalisé par les couches 25, 26, et il n'y a pas lieu de recourir à des techniques complexes à deux couches successives conformes à l'art traditionnel en la matière.

8/ Huitième étape (figure 11) : définition des connexions métalliques à l'aide d'un troisième niveau lithographique.

Typiquement la surface protégée par la résine photosensible recouvre les ouvertures précédentes de 1 à 2 micromètres, afin d'assurer la continuité électrique métallique entre l'électrode de nitrure de titane et l'entrée du circuit de lecture, via le pilier ainsi constitué.

9/ Neuvième étape : gravure du tungstène, et du titane, ou de la couche unique de titane suivant la variante énoncée plus haut puis gravure de l'aluminium de l'étape 4, par les procédés usuels de gravure.

On effectue le retrait de la résine photosensible par les moyens usuels.

10/ Dixième étape (figure 12) : définition, à l'aide d'un quatrième niveau lithographique, de la couche de nitrure de titane.

Cette couche constitue les électrodes du bolomètre. Le dessin du masque doit donc être conforme aux principes de dessin énoncés précédemment, qui n'impliquent pas de définition lithographique fine. Des moyens peu sophistiqués suffisent (lithographie par proximité/contact) pour l'optimisation dans la bande 8-12μm. Après cette gravure la résine photosensible est éliminée par les moyens usuels. Suivant la configuration préférée, on définit des électrodes interdigitées de 2.5 à 4 micromètres de largeur, espacées de 2.5 à 4 micromètres, suivant un réseau parallèle simple.

11/ Onzième étape (figure 13) : dépôt du matériau bolométrique (27), typiquement, mais pas exclusivement, du silicium amorphe dopé.

Ce type de dépôt relève de l'art connu en ce qui concerne l'optimisation et le contrôle de la résistivité en fonction du mélange de gaz et des autres paramètres de dépôt. La résistivité du matériau doit être adaptée au dessin des électrodes, ou réciproquement le dessin des électrodes peut être adapté à la résistivité maximale que l'on sait reproduire. Dans la configuration préférée, on dépose typiquement 1000 Angström de silicium amorphe PECVD de type p à 200 KΩcm de résistivité, en mettant en oeuvre le mélange de gaz adéquat.

12/ Douzième étape (figure 14) : définition et gravure du ( ou des) point(s) élémentaire(s) et des bras d'isolation thermique à l'aide d'un cinquième et dernier niveau lithographique selon les techniques de l'homme de l'art.

13/ Treizième étape : libération des microstructures, typiquement à l'aide d'une gravure sèche oxydante telle que pratiquée par l'homme de l'art, pour l'élimination sèche des résines photosensibles.

Dans la pratique il est nécessaire de réaliser le test ou tri de fonctionnalité et surtout la découpe des composants avant de libérer les structures, pour des raisons de fragilité et de contamination pendant ces différentes étapes. Après libération, les dispositifs sont montés sous vide en enceinte, régulable en température, comportant les éléments optiques nécessaires.

On va à présent considérer successivement plusieurs variantes du dispositif de l'invention.

Le nitrure de titane et le silicium amorphe présentent usuellement un niveau de contraintes internes élevé. La disposition la plus simple proposée en deux couches superposées (configuration dite "préférée") peut conduire à des déformations importantes, après l'étape de libération, par effet "bilame".

Il est dans ce cas avantageux de compenser cet effet en disposant judicieusement des couches adéquates de part et d'autre des éléments conducteurs. Ainsi, comme précisé précédemment, on peut déposer le matériau sensible de part et d'autre des éléments conducteurs ; on peut aussi déposer sur une face des éléments conducteurs le matériau sensible et sur l'autre face une couche de matériau passif. Enfin, on peut aussi déposer sur la (ou les) face(s) du matériau sensible non en contact avec les éléments conducteurs une couche de matériau passif.

Le matériau dit passif est de préférence un matériau à faible conductivité thermique car ces couches se retrouvent également dans les bras d'isolement. On utilise donc de manière préférentielle de l'oxyde de silicium (SiO), du nitrure de silicium (SiN) ou encore de silicium amorphe déposé suivant les méthodes traditionnelles.

On peut ainsi sans compliquer notablement le procédé déposer par exemple une couche 30 de 100 à 200 Angström d'oxyde de silicium ou de nitrure de silicium ou encore de silicium amorphe en surface du polyimide, avant dépôt de l'électrode de nitrure de titane, ou/et une couche 31 identique après dépôt du matériau sensible. Ces deux couches sont gravées avec les autres lors de la douzième étape.

La configuration préférée est un empilement symétrique qui stabilise efficacement la structure, conformément à la figure 15. Un avantage associé à cette disposition est l'effet de passivation électrique des surfaces non métallisées de matériau sensible ou non en regard des électrodes.

La masse supplémentaire peut simplement être compensée par une diminution équivalente de la couche de matériau sensible par exemple en silicium amorphe. En effet, les densités et capacités calorifiques intrinsèques du nitrure de silicium, de l'oxyde de silicium et du silicium amorphe ne sont pas très différentes, pas plus que leurs conductibilités thermiques respectives.

Une autre configuration avantageuse est réalisable, toujours dans le but d'améliorer la stabilité mécanique des structures libérées, et éventuellement la stabilité électrique des bolomètres. Elle consiste en une répartition symétrique des couches actives (et éventuellement passives) de part et d'autre de l'électrode de nitrure de titane, conformément à la figure 16.

Il suffit de déposer dans le cas le plus sophistiqué où on passive les surfaces du silicium amorphe en surface du polyimide (entre la première étape et la seconde étape) par exemple une couche 32 de 100 à 200 Angstrom de nitrure de silicium, puis une couche de 300 à 400 Angström de silicium amorphe faiblement dopé. Lors de la onzième étape on répète cette séquence, mais inversée, c'est-à-dire 300 à 400 Angstrôm de silicium faiblement dopé (34), puis 100 à 200 Angström de nitrure de silicium (35).

Toutes les couches empilées sont alors gravées lors de la douzième étape, comme précédemment. La masse totale est semblable à l'empilement de référence, mais la structure est particulièrement stable par construction, car parfaitement symétrique. De plus l'électrode de nitrure de titane centrale réalise le contact du silicium amorphe sur ses deux faces, ce qui va dans le sens de l'amélioration de l'injection du courant traversant la structure.

Les figures 8 à 16, qui illustrent le procédé de l'invention représentent des vues en coupe de la structure réalisée, ainsi que des vues des niveaux lithographiques, aux différentes étapes dudit procédé ou des variantes de celui-ci.

La figure 8A illustre une coupe AA' représentée sur la figure 8B après définition du réflecteur 21.

La figure 9A illustre une coupe AA' représentée sur la figure 9B après définition des ouvertures de connexion 30.

La figure 10 illustre une coupe AA' après dépôt de métallisation d'interconnexion.

La figure 11A illustre une coupe AA' illustrée sur la figure 11B après définition de l'interconnexion métallique ; des réservations métalliques 31 étant représentées sur la figure 11B.

La figure 12A illustre une coupe AA' illustrée sur la figure 12B après définition des électrodes avec une épaisseur de tungstène plus importante (configuration "plug") ; la référence 32 sur la figure 12B illustrant un motif ouvert (zone gravée).

La figure 13 illustre une coupe AA' après dépôt du matériau bolométrique.

La figure 14A illustre une coupe AA' représentée sur la figure 14B après réticulation.

La figure 15 illustre une coupe AA' d'une structure passivée (première variante).

La figure 16 illustre une structure passivée symétrique (seconde variante).

## Revendications

1. Détecteur infrarouge, comprenant :

   - une partie sensible comportant

     • un élément sensible comportant une couche de matériau dont la résistivité varie avec la température,
     • des éléments conducteurs (13, 13') permettant d'assurer les fonctions d'électrodes dudit détecteur et d'absorbeur infrarouge ;

   - au moins un élément de support (11) de la partie sensible apte à positionner ladite partie sensible, à la relier électriquement à un circuit de lecture et à l'isoler thermiquement du reste de la structure ;

   **caractérisé en ce que** tous les éléments conducteurs sont disposés sur la même face de la couche de matériau sensible à la température.

2. Détecteur selon la revendication 1, **caractérisé en ce que** les éléments conducteurs comportent deux électrodes interdigitées réalisant simultanément les fonctions d'électrodes et d'absorbeur, ces électrodes étant reliées au circuit de lecture.

3. Détecteur selon la revendication 1, **caractérisé en ce que** les éléments conducteurs comportent deux électrodes d'un premier type reliées au circuit de lecture et au moins une électrode d'un second type porté à un potentiel flottant, l'électrode du second type assurant uniquement la fonction d'absorbeur et les électrodes du premier type assurant simultanément les fonctions d'électrodes et d'absorbeur.

**4.** Détecteur selon l'une quelconque des revendications précédentes, **caractérisé en ce qu'**au moins deux éléments conducteurs assurent la connexion électrique vers le circuit de lecture.

**5.** Détecteur selon l'une quelconque des revendications précédentes, **caractérisé en ce que** ladite face de la couche de matériau sensible est la face inférieure, les éléments conducteurs étant disposés sous ladite couche.

**6.** Détecteur selon l'une quelconque des revendications 1 à 4, **caractérisé en ce que** ladite face de la couche de matériau sensible est la face supérieure, les éléments conducteurs étant disposés sur ladite couche.

**7.** Détecteur selon l'une quelconque des revendications 1 à 4, **caractérisé en ce que** les éléments conducteurs sont insérés entre deux couches de matériau sensible.

**8.** Détecteur selon la revendication 1, **caractérisé en ce que** le matériau sensible à la température est du silicium amorphe ou de l'oxyde de vanadium.

**9.** Détecteur selon la revendication 1, **caractérisé en ce que** l'espace libre défini entre les éléments conducteurs (13, 13') est constitué uniquement de matériau sensible à la température.

**10.** Détecteur selon la revendication 1, **caractérisé en ce qu'**un réflecteur (21) est prévu en surface du substrat supportant le circuit de lecture, et situé à λ/4 sous le plan de l'élément sensible, λ étant la longueur d'onde typique du rayonnement reçu.

**11.** Détecteur selon la revendication 1, **caractérisé en ce que** le motif des éléments conducteurs est répété suivant un pas compris typiquement entre λ et λ/2 pour obtenir une absorption moyenne supérieure à 90%.

**12.** Détecteur selon la revendication 1, **caractérisé en ce que** chaque élément support comporte au moins un pilier de connexion et au moins un bras.

**13.** Détecteur infrarouge, **caractérisé en ce qu'**il est constitué d'un ensemble de détecteurs selon l'une quelconque des revendications 1 à 12.

**14.** Procédé de fabrication d'un détecteur infrarouge selon l'une quelconque des revendications précédentes, **caractérisé en ce qu'**en partant d'un circuit de lecture déjà achevé à partir d'un substrat, il comporte les étapes suivantes :

a) formation d'une couche sacrificielle ;
b) dépôt d'au moins une couche conductrice pour la réalisation des éléments conducteurs ;
c) réalisation d'au moins une ouverture de contact vers le circuit de lecture par gravure localisée de la couche conductrice et de la couche sacrificielle ;
d) dépôt d'au moins un matériau conducteur et gravure de ce dernier de façon à assurer la liaison électrique entre les éléments conducteurs et le circuit de lecture, le motif ainsi réalisé formant le pilier du support ;
e) gravure de la couche conductrice déposée à l'étape b) de façon à définir les motifs des éléments conducteurs ;
f) dépôt sur l'ensemble, de la couche de matériau sensible à la température et gravure des différentes couches disposées au-dessus de la couche sacrificielle de façon à définir l'élément sensible et le bras du support ;
g) gravure de la couche sacrificielle de façon à libérer la partie sensible, et le pilier.

**15.** Procédé selon la revendication 14, **caractérisé en ce que** l'étape f) de dépôt de matériau sensible est réalisée avant l'étape b), le matériau sensible étant alors gravé à l'étape c).

**16.** Procédé selon la revendication 14, **caractérisé en ce que** le matériau sensible est déposé selon une première couche avant l'étape b) et en une deuxième couche à l'étape f), la première couche de matériau sensible étant alors gravée à l'étape c).

**17.** Procédé selon la revendication 14, **caractérisé en ce que** l'étape d) est réalisée après l'étape b).

**18.** Procédé selon la revendication 14, **caractérisé en ce qu'**on réalise préalablement à l'étape a), le dépôt et la gravure d'une couche métallique pour former un réflecteur.

**19.** Procédé selon la revendication 14, **caractérisé en ce que** la couche sacrificielle est une couche de polyimide à laquelle on a fait subir un recuit.

**20.** Procédé selon la revendication 14, **caractérisé en ce que** la couche conductrice de l'étape b) est une bicouche de nitrure de titane et d'aluminium, le matériau conducteur de l'étape d) étant déposé alors après réalisation des étapes b) et c), ce matériau conducteur et l'aluminium étant ensuite gravés de la même façon à l'étape d).

**21.** Procédé selon la revendication 14, **caractérisé en ce que** le matériau conducteur de l'étape d) est un multicouche dont au moins une des couches est formée par LPCVD.

**22.** Procédé selon la revendication 14, **caractérisé en ce que** les éléments conducteurs présentant une première et une deuxième faces, le matériau sensible étant en contact avec l'une des faces desdits éléments, l'autre face est mise en contact avec une couche de matériau passif.

**23.** Procédé selon la revendication 14, **caractérisé en ce qu'**une couche de matériau passif est déposée sur la ou les faces du matériau sensible, non en contact avec les éléments conducteurs.

**24.** Procédé selon la revendication 23, **caractérisé en ce que** le matériau passif est choisi parmi l'oxyde de silicium, le nitrure de silicium et le silicium amorphe.

**Claims**

**1.** Infrared detector including:

- a sensitive part comprising

  • a sensitive element comprising a layer of material in which the resistivity varies with the temperature,
  • conducting elements (13, 13') carrying out the functions of electrodes for the said detector and infrared absorber;

- at least one support element (11) for the sensitive part capable of positioning the said sensitive part, electrically connecting it to a readout circuit and thermally insulating it from the rest of the structure, **characterized in that** all conducting elements are placed on the same surface of the layer of temperature sensitive material.

**2.** Detector according to claim 1, **characterized in that** the conducting elements comprise two interleaved electrodes simultaneously performing the functions of electrodes and absorbers, these electrodes being connected to the readout circuit.

**3.** Detector according to claim 1, **characterized in that** the conducting elements comprise two electrodes of a first type connected to the readout circuit, and at least one electrode of second type at a floating potential, the electrode of the second type performing solely the absorber function and the electrodes of the first type performing the functions of electrodes and absorber at the same time.

**4.** Detector according to any one of the preceding claims, **characterized in that** at least two conducting elements provide the electrical connection to the readout circuit.

**5.** Detector according to any one of the preceding claims, **characterized in that** the said surface of the sensitive material layer is the lower surface, the conducting elements being located on the said layer.

**6.** Detector according to any one of the claims 1 to 4, **characterized in that** the said surface of the layer of sensitive material is the upper surface, the conducting elements being located on the said layer.

**7.** Detector according to any one of the claims 1 to 4, **characterized in that** the conducting elements are inserted between two layers of sensitive material.

**8.** Detector according to claim 1, **characterized in that** the temperature sensitive material is amorphous silicon or vanadium oxide.

**9.** Detector according to claim 1, **characterized in that** the free space defined between the conducting elements (13, 13') is composed solely of temperature sensitive material.

**10.** Detector according to claim 1, **characterized in that** a reflector (21) is provided on the surface of the substrate supporting the readout circuit, and located at $\lambda/4$ under the plane of the sensitive element, where $\lambda$ is the typical wavelength of the received radiation.

**11.** Detector according to claim 1, **characterized in that** the pattern of the conducting elements is repeated at a pitch typically between $\lambda$ and $\lambda/2$ to obtain an average absorption exceeding 90%.

**12.** Detector according to claim 1, **characterized in that** each support element includes at least one connection pillar and at least one arm.

**13.** Infrared detector which is composed of a set of detectors according to any one of the claims 1 to 12.

**14.** Process for the manufacture of an infrared detector according to any one of the preceding claims, **characterized in that** it comprises the following steps, starting from a previously manufactured readout circuit made on a substrate:

   a) formation of a sacrificial layer;
   b) deposit of at least one conducting layer to make conducting elements;
   c) make at least one contact opening to the readout circuit by local etching of the conducting layer and the sacrificial layer;
   d) deposit of at least one conducting material and etching of this material in order to form the electrical connection between conducting elements and the readout circuit, the pattern thus being formed making up the support pillar;

e) etching of the conducting layer deposited in step b) in order to define the patterns of the conducting elements;

f) deposit of the temperature sensitive material on the assembly, and etching of the various layers located above the sacrificial layer in order to define the sensitive element and the support arm;

g) etching of the sacrificial layer so as to release the sensitive part and the pillar.

**15.** Process according to claim 14, **characterized in that** step f) depositing the sensitive material is done before step b), the sensitive material then being etched in step c).

**16.** Process according to claim 14, **characterized in that** the sensitive material is deposited as a first layer before step b) and as a second layer in step f), the first layer of sensitive material then being etched in step c).

**17.** Process according to claim 14, **characterized in that** step d) is done before step b).

**18.** Process according to claim 14, **characterized in that** a metallic layer is deposited and etched to form a reflector, before step a).

**19.** Process according to claim 14, **characterized in that** the sacrificial layer is a polyimide layer which is annealed.

**20.** Process according to claim 14, **characterized in that** the conducting layer in step b) is a dual layer of titanium nitride and aluminium, the conducting material in step d) then being deposited after completing steps b) and c), this conducting material and the aluminium then being etched in the same way as in step d).

**21.** Process according to claim 14, **characterized in that** the conducting material in step d) is the multilayer, at least one of the layers being formed by LPCVD.

**22.** Process according to claim 14, **characterized in that** the conducting elements have first and second surfaces, the sensitive material being in contact with one of the surfaces of the said elements, the other surface being in contact with a layer of passive material.

**23.** Process according to claim 14, **characterized in that** a layer of passive material is deposited on the surface(s) of the sensitive material not in contact with conducting elements.

**24.** Process according to claim 23, **characterized in that** the passive material is chosen from silicon oxide, silicon nitride and amorphous silicon.

## Patentansprüche

**1.** Infrarot-Detektor, enthaltend:

- einen empfindlichen Teil, umfassend:

  • ein empfindliches Element, das eine Schicht aus einem Material enthält, dessen Resistivität sich mit der Temperatur verändert,
  • leitfähige Elemente (13, 13'), fähig die Funktionen der Elektroden des genannten Detektors und des Infrarot-Absorbers zu erfüllen;

- mindestens ein Trägerelement (11) des empfindlichen Teils, fähig den genannten empfindlichen Teil zu positionieren, ihn elektrisch mit einer Leseschaltung zu verbinden und ihn elektrisch von dem Rest der Struktur zu isolieren;

  **dadurch gekennzeichnet,**
  **dass** alle leitfähigen Elemente auf derselben Seite der Schicht aus Temperatur-empfindlichem Material angeordnet sind.

**2.** Detektor nach Anspruch 1, **dadurch gekennzeichnet, dass** die leitfähigen Elemente zwei interdigitierte bzw. ineinandergreifende Elektroden umfassen, die zugleich die Elektroden- und die Absorberfunktion erfüllen, wobei diese Elektroden mit der Leseschaltung verbunden sind.

**3.** Detektor nach Anspruch 1, **dadurch gekennzeichnet, dass** die leitfähigen Elemente zwei Elektroden eines ersten Typs umfassen, die mit der Leseschaltung verbunden sind, und mindestens eine Elektrode eines zweiten Typs, an die ein Schwebepotential angelegt ist, wobei die Elektrode des zweiten Typs nur die Absorberfunktion erfüllt und die Elektroden des ersten Typs zugleich die Elektroden- und die Absorberfunktion erfüllen.

**4.** Detektor nach einem der vorangehenden Ansprüche, **dadurch gekennzeichnet, dass** wenigstens zwei leitfähige Elemente die elektrische Verbindung mit der Leseschaltung sicherstellen.

**5.** Detektor nach einem der vorangehenden Ansprüche, **dadurch gekennzeichnet, dass** die genannte Seite der Schicht aus empfindlichen Material die untere Seite ist, wobei die leitfähigen Elemente unter der genannten Schicht angeordnet sind.

6. Detektor nach einem der Ansprüche 1 bis 4, **dadurch gekennzeichnet, dass** die genannte Seite der Schicht aus empfindlichem Material die obere Seite ist, wobei die leitfähigen Elemente auf der genannten Schicht angeordnet sind.

7. Detektor nach einem der Ansprüche 1 bis 4, **dadurch gekennzeichnet, dass** die leitfähigen Elemente zwischen zwei Schichten aus empfindlichem Material enthalten sind.

8. Detektor nach Anspruch 1, **dadurch gekennzeichnet, dass** das Temperaturempfindliche Material amorphes Silicium oder Vanadiumoxid ist.

9. Detektor nach Anspruch 1, **dadurch gekennzeichnet, dass** der zwischen den leitfähigen Elementen (13, 13') definierte freie Raum nur durch Temperatur-empfindliches Material gebildet wird.

10. Detektor nach Anspruch 1, **dadurch gekennzeichnet, dass** ein Reflektor (21) an der Oberfläche des die Leseschaltung tragenden Substrats vorgesehen ist und sich um $\lambda/4$ unter der Ebene des empfindlichen Elements befindet, wobei $\lambda$ die typische Wellenlänge der empfangenen Strahlung ist.

11. Detektor nach Anspruch 1, **dadurch gekennzeichnet, dass** das Muster der leitfähigen Elemente sich gemäß einer Teilung wiederholt, die typisch zwischen $\lambda$ und $\lambda/2$ enthalten ist, um eine durchschnittliche Absorption von über 90% zu erhalten.

12. Detektor nach Anspruch 1, **dadurch gekennzeichnet, dass** jedes Tragelement mindestens einen Verbindungspfeiler und mindestens einen Arm umfasst.

13. Infrarot-Detektor, **dadurch gekennzeichnet, dass** er durch eine Detektoreneinheit nach einem der Ansprüche 1 bis 12 gebildet wird.

14. Herstellungsverfahren eines Infrarot-Detektors nach einem der vorangehenden Ansprüche, **dadurch gekennzeichnet, dass** es, ausgehend von einer schon auf einem Substrat realisierten Leseschaltung, die folgenden Schritte umfasst:

    a) Bilden einer Opferschicht;
    b) Abscheiden von mindestens einer leitfähigen Schicht, um die leitfähigen Elemente herzustellen;
    c) Herstellen von mindestens einer Kontaktöffnung zu der Leseschaltung durch lokalisiertes Ätzen der leitfähigen Schicht und der Opferschicht;
    d) Abscheiden von mindestens einem leitfähigen Material und Ätzen dieses letzteren, um die elektrische Verbindung zwischen den leitfähigen Elementen und der Leseschaltung herzustellen, wobei das derart entstandene Muster den Stützpfeiler bildet;
    e) Ätzen der in Schritt b) abgeschiedenen leitfähigen Schicht, um die Muster der leitfähigen Elemente zu definieren;
    f) über dem Ganzen dann Abscheiden der Schicht aus Temperatur-empfindlichem Material und Ätzen der verschiedenen, über der Opferschicht abgeschiedenen Schichten, um das empfindliche Element und den Tragarm zu definieren;
    g) Ätzen der Opferschicht, um den empfindlichen Teil und den Pfeiler freizumachen.

15. Verfahren nach Anspruch 14, **dadurch gekennzeichnet, dass** der Abscheidungsschritt f) des empfindlichen Materials vor dem Schritt b) erfolgt, wobei das empfindliche Material dann im Schritt c) geätzt wird.

16. Verfahren nach Anspruch 14, **dadurch gekennzeichnet, dass** das empfindliche Material als eine erste Schicht vor dem Schritt b) und als eine zweite Schicht in Schritt f) abgeschieden wird, wobei die erste Schicht aus empfindlichem Material dann im Schritt c) geätzt wird.

17. Verfahren nach Anspruch 14, **dadurch gekennzeichnet, dass** der Schritt d) nach dem Schritt b) ausgeführt wird.

18. Verfahren nach Anspruch 14, **dadurch gekennzeichnet, dass** man vor dem Schritt a) eine metallische Schicht abscheidet und ätzt, um einen Reflektor zu bilden.

19. Verfahren nach Anspruch 14, **dadurch gekennzeichnet, dass** die Opferschicht eine Polyimidschicht ist, die man einer thermischen Behandlung unterzieht.

20. Verfahren nach Anspruch 14, **dadurch gekennzeichnet, dass** die leitfähige Schicht des Schritts b) eine Titannitrid-Aluminium-Doppelschicht bzw. -Doppelzusammensetzungsschicht ist, wobei das leitfähige Material des Schritts d) dann nach Ausführung der Schritte b) und c) abgeschieden wird und dieses leitfähige Material und das Aluminium anschließend geätzt wird wie beschrieben in Schritt d).

21. Verfahren nach. Anspruch 14, **dadurch gekennzeichnet, dass** das leitfähige Material des Schritts d) eine Multischicht ist, bei der mindestens eine der Schichten durch LPCVD erzeugt wird.

22. Verfahren nach Anspruch 14, **dadurch gekennzeichnet, dass** die leitfähigen Elemente eine erste und eine zweite Seite aufweisen und das empfindliche Material Kontakt hat mit einer der Seiten der genannten Elemente, wobei die andere Seite mit einer Schicht aus passivem Material Kontakt hat.

23. Verfahren nach Anspruch 14, **dadurch gekennzeichnet, dass** die Schicht aus passivem Material auf der oder den Seiten des empfindlichen Materials abgeschieden wird, die keinen Kontakt mit den leitfähigen Elementen haben.

24. Verfahren nach Anspruch 23, **dadurch gekennzeichnet, dass** das passive Material ausgewählt wird unter Siliciumoxid, Siliciumnitrid und amorphem Silicium.

EP 0 828 145 B1

FIG. 1A

FIG. 1B

FIG. 2A

FIG. 2B

FIG. 3A

FIG. 3B

$p2 \# \lambda/2$

$p1 \# \lambda$

13

13'

FIG. 4 A

$p2 \ll \lambda$

13'

$p1 \# \lambda$

13

FIG. 4 B

$\lambda/2 < P < \lambda$

13     13′

13″

FIG. 5A

$\lambda/2 < P < \lambda$

13     13′

13″

FIG. 5B

FIG. 6

FIG. 7

FIG. 8A

FIG. 8B

FIG. 9A

FIG. 9B

FIG. 10

FIG. 11A

FIG. 11B

FIG. 12 A

FIG. 12B

FIG. 13

FIG. 14 A

FIG. 15

FIG. 16

FIG. 14 B